# EUROPÄISCHE PATENTANMELDUNG

(11) **EP 2 280 422 A2**
(43) Veröffentlichungstag der Anmeldung: **02.02.2011**
(21) Anmeldenummer: 10007824.5
(22) Anmeldetag: 28.07.2010
(51) Int. Cl.: H01L 31/052

(54) **Kühlelement für Solarzellenmodule**

(30) Priorität: 28.07.2009 DE 202009010235 U
(71) Anmelder: SHS, Solar House Systems GmbH, 72186 Empfingen (DE)
(72) Erfinder:
(74) Vertreter: Klocke, Peter

(57) **Zusammenfassung**

Kühlelement für ein Solarzellenmodul, das mehrere matrixartig angeordnete Solarzellen aufweist, die zusammen eine ebene Modulrückseite bilden, wobei eine Kühlelementkassette (1) mit mehreren parallel zueinander verlaufenden nebeneinander angeordneten Kühlkanälen (9,10) vorgesehen ist, welche jeweilse eine zum Solarzellenmodul hin gerichtete ebene Kanalwand (7, 21) zum flächigen Kontaktieren der Modulrückseite aufweisen. Die Kühlkanäle (9, 10) sind von einem Kühlmedium durchströmt und in Strömungsrichtung über Verbindungskanäle miteinander verbunden. Die Kühlkanäle (9, 10) sind über die Verbindungskanäle einzeln oder gruppenweise parallel und/oder hintereinander geschaltet. Erfindungsgemäß weist das Kühlelement eine Kühlelementkassette (1) auf, die von einer Deckplatte (7) eine innere Verteilerplatte (2) und einer Bodenplatte (8) gebildet ist, wobei die Verteilerplatte (2) wellenartig ausgebildet ist und oberseitig durch die Deckplatte (7) und unterseitig durch die Bodenplatte (8) vollflächig unter Ausbildung der Kühlkanäle (9,10) abgedeckt ist.

## Beschreibung

Die Erfindung betrifft ein Kühlelement für ein Solarzellenmodul, das mehrere matrixartig angeordnete Solarzellen aufweist, die zusammen eine ebene Modulrückseite bilden, mit mehreren parallel zueinander verlaufenden, nebeneinander angeordneten Kühlkanälen, welche jeweils eine zum Solarzellenmodul hin gerichtete ebene Kanalwand zum flächigen Kontaktieren der Modulrückseite aufweisen, wobei die Kühlkanäle von einem Kühlmedium durchströmt sind und in Strömungsrichtung über Verbindungskanäle miteinander verbunden sind.

Solarmodule sind schon seit längerem bekannt und bekannterweise mehrschichtig aufgebaut. Zentraler Bestandteil solcher Solarmodule sind sog. Solarzellen, welche in einer im Wesentlichen rechteckigen Matrix angeordnet sind. Solche Solarzellen stehen untereinander elektrisch miteinander in Verbindung und weisen in der Regel einen gemeinsamen Außenanschluss auf. Dabei sind die einzelnen Solarzellen elektrisch in Reihe geschaltet, um eine entsprechend höhere Ausgangsspannung des gesamten Solarmoduls zu erreichen. Das Solarmodul selbst bildet in der Regel eine rechteckige Grundform, welche zur Lichtseite hin eine Glasplatte aufweist. Rückseitig ist diese Glasplatte mit einer Kunststoffschicht versehen, in welche die Solarzellen eingebettet sind. Auf ihrer der Glasplatte gegenüberliegenden Seite sind diese Solarzellen des Weiteren mit einer Schutzfolie abgedeckt. Da sowohl die Kunststoffschicht als auch die Schutzfolie in einem Laminierprozess aufgebracht werden, sind am Ende dieses Prozesses die einzelnen Solarzellen zusammen mit ihrer elektrischen Kontaktierung zwischen der Kunststoffschicht und der Schutzfolie eingebettet. Dieser Schichtaufbau, bestehend aus der Glasplatte, der Kunststoffschicht, den Solarzellen sowie der rückseitigen Schutzfolie wird in der Regel durch einen Profilrahmen fixiert, welcher im Kantenbereich des Solarzellenmoduls angeordnet ist. Dabei besteht diese Rahmenkonstruktion in der Regel aus U-förmigen Aluminiumprofilen, welche oberseitig und unterseitig entsprechend der Materialstärke der Aluminiumprofile über die Oberseite bzw. Unterseite des Solarzellenmoduls vorstehen.

Im Betrieb solcher Solarzellenmodule hat sich nun gezeigt, dass deren Leistungsfähigkeit mit zunehmender Temperatur abnimmt. Insbesondere bei Temperaturen über 45°C kann der Leistungsverlust solcher Solarzellenmodule erheblich sein und deutlich über 15 liegen. Dementsprechend ist es für eine optimale Leistungsausbeute sinnvoll, die Solarzellenmodule, insbesondere im Bereich der Solarzellen zu kühlen, um diese auf einer optimalen Leistungstemperatur zu halten. Weiter können solche Solarzellenmodule unterseitig mit zusätzlich stabilisierenden Glasplatten versehen sein. Dementsprechend sind auch solche Solarzellenmodule mit einer entsprechenden Rahmenkonstruktion versehen, durch welche insbesondere eine Beschädigung der Kantenbereiche der oberseitigen und unterseitigen Glasplatten verhindert wird. Weiter dient diese Rahmenkonstruktion auch zur späteren Montage der Solarzellenmodule.

Aufgrund der temperaturabhängigen Leistungsfähigkeit solcher Solarzellenmodule liegt der Erfindung die Aufgabe zugrunde, eine Möglichkeit zu schaffen, die Solarzellen oder das gesamte Solarzellenmodul auf einer optimalen Temperatur zu halten.

Die Aufgabe wird erfindungsgemäß durch ein Kühlelement mit den Merkmalen des Anspruches 1 gelöst. Weitere vorteilhafte Ausgestaltungen der Erfindung sind den rückbezogenen Patentansprüchen zu entnehmen.

Das erfindungsgemäße Kühlelement weist mindestens eine Kühlelementkassette auf, deren Kühlkanäle über Verbindungskanäle einzeln oder gruppenweise parallel und/oder hintereinander geschaltet sind. Diese Merkmale sind zusammen mit den Merkmalen der Oberbegriffes ausgebildet, gemäß dem das Kühlelement mehrere parallel zueinander verlaufende, nebeneinander angeordnete Kühlkanäle aufweist, welche in Strömungsrichtung über die Verbindungskanäle miteinander verbunden sind, wobei die Kühlkanäle jeweils eine zum Solarzellenmodul hin gerichtete ebene Kanalwand bilden, mit welcher die Kühlkanäle flächig auf der Rückseite des Solarzellenmoduls aufsetzbar sind. Die Kühlkanäle der Kühlelementkassette sind von einem Kühlmedium durchströmt. Das Kühlelement kann mehrere derartige Kühlelementkassetten aufweisen, die hintereinander und/oder nebeneinander angeordnet sind und deren Kühlkanäle in Strömungsrichtung einzeln oder gruppenweise über Verbindungselemente parallel und/oder hintereinander geschaltet sind. Die mindestens eine Kühlelementkassette deckt das Solarmodul rückseitig zumindest im Bereich der Solarzellen vollständig flächig abdecken.

Durch die erfindungsgemäße Ausgestaltung wird ein Kühlelement zur Verfügung gestellt, weiches mit dem Solarzellenmodul optimal in thermische Wirkverbindung bringbar ist. Hierzu ist insbesondere vorgesehen, dass die in der Kühlelementkassette angeordneten Kühlkanäle jeweils eine zum Solarzellenmodul hin gerichtete ebene Kanalwand bilden. Durch diese ebene Ausbildung der Kanalwand ist eine optimale Wärmeübertragung bzw. Ternperaturübertragung vom Solarzellenmodul zu der Kühlelementkassette des Kühlelementes gewährleistet. Die Kühlkanäle der Kühlelementkassette sind dabei flächig auf der Rückseite des Solarzellenmoduls aufgesetzt, wobei zu deren Verbindung beispielsweise eine Klebverbindung vorgesehen sein kann. Zur Temperierung, insbesondere zur Külhlung des gesamten Solarmoduls zumindest im Bereich der Solarzellen sind die Kühlkanäle der Kühlelementkassette von einem Kühlmedium durchströmt, wobei die Strömungsgeschwindigkeit bzw. Aktivierung dieses Kühlmediums auch elektronisch gesteuert vorgenommen werden kann. Je nach Größe und Aufbau des Solarzellenmoduls können diese Kühlkanäle bezüglich der Durchströmung; parallel zueinander und/oder hintereinander geschaltet sein. Dabei kann diese parallele oder hintereinander geschaltete Anordnung einzeln oder gruppenweise vorgenommen sein. Hierzu stehen diese einzelnen Kühlkanäle über entsprechende Verbindungskanäle strömungstechnisch miteinander in Verbindung. An den Verbindungskanälen sowie an ggf. vorgesehenen Verbindungselemente herrscht eine turbulente Strömung vor, während in den Kühlkanäle das Kühlmedium vorwiegend laminar strömt.

Vorzugsweise ist die Kühlelementkassette von einer Deckplatte, einer inneren Verteilerplatte und einer Bodenplatte gebildet ist, wobei die Verteilerplatte wellenartig ausgebildet ist und oberseitig durch die Deckplatte und unterseitig durch die Bodenplatte vollflächig unter Ausbildung der Kühlkanälen abgedeckt ist. Dabei können die Verbindungskanäle als zwischen den Kühlkanälen angeordnete Durchbrüche ausgebildet sein welche in den Endbereichen der Verteilerplatte in der Verteilerplatte angeordnet sind. Bei einer zweckmäßigen Ausführungsform der Erfindung stehen die Verteilerplatte, die Deckplatte und die Bodenplatte durch umlaufend angeordnete Stirnwände und Seitenwände miteinander feststehend in Verbindung. Vorteilhafterweise können an der Kühlelementkassette bzw. an dem Kühlelement zur Zuführung und zum Abführen des Kühlmediums wenigstens zwei Rohrstutzen vorgesehen sein, welche vorzugsweise in den seitlichen Endbereichen wenigstens einer der Stirnwände angeordnet sind.

Bei einer bevorzugten Ausführungsform des erfindungsgemäßen Kühlelementes ist ein Montagelement vorgesehen, in welches die mindestens eine Kühlelementkassette einsetzbar ist. Das Montagelement ist dabei vorzugsweise mit zumindest teilweise umlaufenden Aufnahmestegen versehen, welche zur positionsgenauen Aufnahme der Kühlelementkassette(n) dienen. Dabei können diese Aufnahmestege erfindungsgemäß im Bereich der Rohrstutzen Durchbrüche aufweisen, durch welche die Rohrstutzen nach außen aus dem Montagelement herausgeführt sind. Es hat sich als günstig erwiesen, dass das die mindestens eine in das Montageelement eingesetzte Kühlelementkassette im am Solarzellenmodul montierten Zustand in einem Profilrahmen des Solarzellenmoduls passend aufgenommen ist. Dabei überragt vorzugsweise die in das Montagelement eingesetzte Kühlelementkassette die Aufnahmestege des Montageelementes zum Solarzellenmodul hin um ein Maß, welches zumindest dem Überstand des Profilrahmen des Solarmoduls zu der Kühlelementkassette hin entspricht. Zur einfachen Positionierung der mindestens einen Kühlelementkassette zwischen den längs verlaufenden Aufnahmestegen und/oder bei mehreren Kühlelementkassetten auch zwischen den Kühlelementkassetten Distanzleisten vorgesehen sein.

Nachfolgend wird die Erfindung anhand eines Ausführungsbeispiels näher erläutert. Weitere Merkmale der Erfindung ergeben sich aus der folgenden Beschreibung des Ausführungsbeispiels der Erfindung in Verbindung mit den Ansprüchen und der beigefügten Zeichnung. Dabei ist die Erfindung nicht auf das dargestellte Ausführungsbeispiel beschränkt, sondern umfasst sämtliche Lösungen, welche insbesondere Kühlkanäle aufweisen, welche großflächig mit dem Solarzellenmodul, insbesondere in den Bereichen die die einzelnen Solarzellen aufweisen, thermisch koppelbar sind. Die einzelnen Merkmale der Erfindung können für sich allein oder zu mehreren bei unterschiedlichen Ausführungsformen der Erfindung verwirklicht sein. Es zeigt:
- Fig. 1: eine perspektivische Explosionsdarstellung einzelner Bauteile einer ersten Ausführungsform eines Kühlelementes;
- Fig. 2: eine Schnittdarstellung eines fertig zusammengesetzten Solar- zellenmoduls mit den Bauteilen aus Fig. 1 sowie einer Deck- platte und einer Bodenplatte;
- Fig. 2a: eine weitere Ausführungsvariante eines Kühlelementes im Teilschnitt mit andersartig ausgestalteten Kühlkanäle;
- Fig. 3: einen vergrößerten Ausschnitt III aus Fig. 1;
- Fig. 4: einen vergrößerten Ausschnitt IV aus Fig. 1;
- Fig. 5: eine perspektivische Darstellung des gesamten Kühlelementes aus den Fig. 1 und Fig. 2 mit entsprechenden Anschlüssen;
- Fig. 6: eine perspektivische Darstellung eines Montageelementes, in welches das Kühlelement aus Fig. 5 passend einsetzbar ist;
- Fig. 7: eine perspektivische Darstellung des Montageelementes aus Fig. 6 mit eingesetztem Kühlelement aus Fig. 5;
- Fig. 8: einen vergrößerten Ausschnitt VIII aus Fig. 7;
- Fig. 9: eine Ausführungsvariante eines Solarzellenmodul in perspekti- vischer Darstellung; F
- Fig. 10: eine Schnittdarstellung des Solarzellenmoduls aus Fig. 9;
- Fig. 11: eine perspektivische Darstellung des Solarzellenmoduls aus Fig. 9 mit adaptiertem Kühlelement sowie Montageelement;
- Fig. 12: eine Schnittdarstellung des Solarzellenmoduls aus Fig. 9 mit adaptiertem Kühlelement sowie Montageelement;

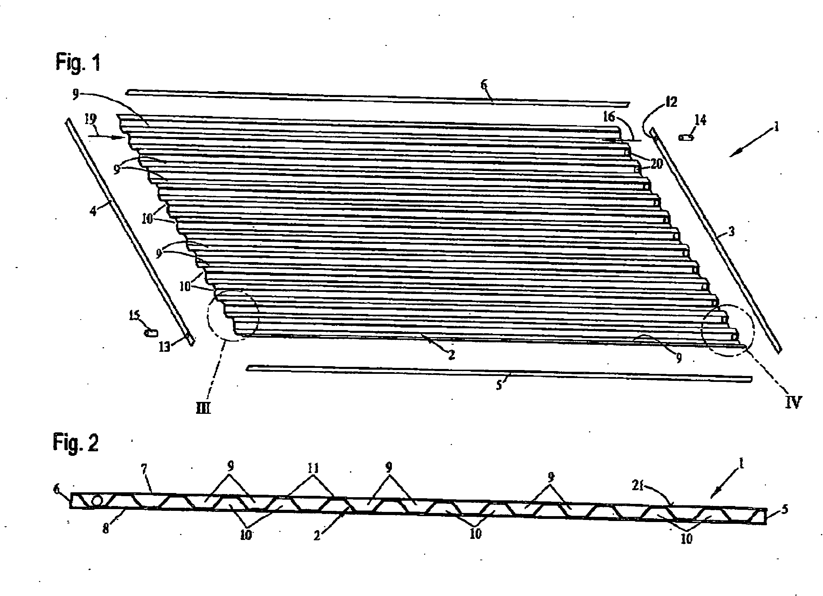

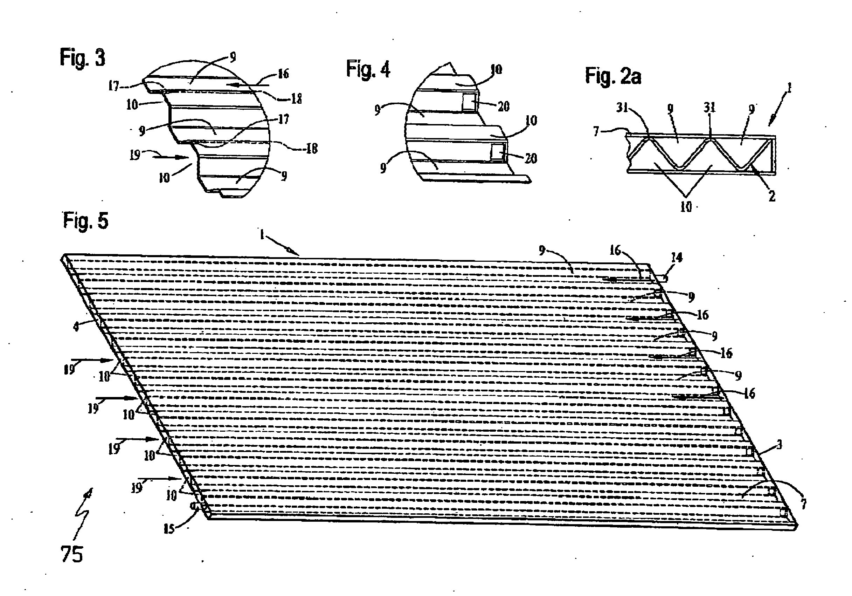

In den Fig. 1 und Fig. 2 ist eine Ausführungsvariante eines Kühlelementes 75 dargestellt, welches eine in Blechbauweise aufgebaute Kühlelementkassette 1 aufweist. Diese Kühlelementkassette 1 weist eine zentrale innere Verteilerplatte 2 auf, welche wellblechartig ausgebildet ist. Die rechten und linken Stirnseiten dieser Verteilerplatte 2 sind mittels zweier Stirnwände 3 und 4 verschließbar. Längsseits sind beidseitig jeweils zwei Seitenwände 5 und 6 vorgesehen, mittels welcher das Kühlelementkassette 1 seitlich verschlossen ist, wie dies insbesondere aus Fig. 2 ersichtlich ist. Des Weiteren ist aus Fig. 2 ersichtlich, dass oberseitig auf die Verteilerplatte 2 eine Deckplatte 7 aufgesetzt ist, welche mit der Verteilerplatte 2 beispielsweise verschweißt oder verklebt sein kann. Unterseitig ist auf die Verteilerplatte 2 eine Bodenplatte 8 aufgesetzt, welche mit der Verteilerplatte 2 ebenfalls verschweißt oder verklebt sein kann.

Aus der Schnittdarstellung der Fig. 2 ist ebenfalls ersichtlich, dass im montierten Zustand der Verteilerplatte 2, der Stirnwände 3, 4, der Seitenwände 5, 6 sowie der Deckplatte 7 und der Bodenplatte 8 durch die Deckplatte 7 und die Bodenplatte 8 in Zusammenwirken mit der Verteilerplatte 2 mehrere Kühlkanäle 9 und 10 gebildet werden. Dabei werden die Kühlkanäle 9 unmittelbar durch die Deckplatte 7 nach oben begrenzt. Diese Deckplatte 7 ist als Blechbauteil ausgebildet und kann eine Blechstärke von 0,5 bis max. 2 mm aufweisen, so dass diese optimale Wärmeleiteigenschaften hat. Als Material für diese Blechbauteile kommt hier beispielsweise Kupfer oder auch jeder andere metallische Werkstoff mit einem relativ hohen Wärmeleitkoeffizienten in Betracht. Auch Kunststoffe oder spezielle Glas- oder Keramikwerkstoffe sind grundsätzlich denkbar.

Die gewellte Verteilerplatte 2 ist oberseitig über Querwände 11 mit der Deckplatte 7 verbunden, so dass sich für die Kühlelementkassette 1 an diesen Stellen bezüglich der Wärmeleitfähigkeit ein etwas schlechterer Wärmeübergang von den untern Kühlkanälen 10 zu der Deckplatte 7 ergibt, als von den oberen Kühlkanälen 9. Jedoch bilden auch diese unteren Kühlkanäle 10 zur Deckplatte 7 hin eine ebene Kontaktfläche, so dass eine entsprechende Kühlwirkung eines auf das Kühlelement 75 aufgesetztes Solarzellenmodul sicher erreichbar ist. Aufgrund der wellenartigen abgekanteten Struktur der Verteilerplatte 2 ergibt sich für die Kühlkanäle 9 und 10 eine Art trapezförmige Grundform.

Des Weiteren ist insbesondere aus Fig. 1 erkennbar, dass die beiden Stirnwände 4 und 5 jeweils eine Durchgangsbohrung 12 bzw. 13 aufweisen, welchen jeweils ein Rohrstutzen 14 bzw. 15 zugeordnet ist. Über diese Rohrstutzen 14 und 15 ist dem Kühlelement 75, insbesondere der Kühlelementkassette 1 ein entsprechendes Kühlmedium, insbesondere eine Kühlflüssigkeit zuführbar bzw. abführbar. Wird dem Kühlelement 75 beispielsweise über den Rohrstutzen 14 ein solches Kühlmedium zugeführt, so entsteht in den oberen Kühlkanälen 9 eine Strömung des Kühlmediums in Richtung des Pfeils 16. Um eine Durchströmung aller Kühlkanäle 9 und 10 zu erreichen, sind diese über Verbindungskanäle 17, 20 im Bereich der Zwischenwände miteinander verbunden.

Wie insbesondere aus Fig. 3 ersichtlich ist, sind im Bereich der linken Stirnwand 4 zwischen den oberen Kühlkanälen 9 und den unteren Kühlkanälen 10 Verbindungskanäle 17 vorgesehen, weiche als Durchbrüche in der Verteilerplatte 2 bzw. den entsprechend zugehörigen Trennwänden 18 zwischen den Kühlkanälen 9 und 10 ausgebildet sind. Dies bedeutet wiederum, dass in den unteren Kühlkanälen 10 das entsprechende Kühlmedium in Richtung des Pfeils 19 zurückfließt und über weitere Verbindungskanäle 20 wiederum in den nächsten benachbarten oberen Kühlkanal 9 gelangt. Diese Verbindungskanäle 20 sind in Fig. 4 vergrößert dargestellt, wobei Fig. 4 einen vergrößerten Ausschnitt IV aus Fig. 1 darstellt. Es ist erkennbar, dass, wie dies insbesondere in den Fig. 3 und Fig. 4 ersichtlich ist, aufgrund der Verbindungskanäle 17 und 20 die Kühlkanäle 9 und 10 strömungstechnisch hintereinander geschaltet sind, so dass das die Kühlelementkassette 1 des Kühlelementes 75 gleichmäßig mit Kühlmedium durchströmt wird. Es kann auch vorgesehen sein, die Kühlkanäle 9 und 10 nur gruppenweise hintereinander zu schalten oder die sich daraus ergebenden Gruppen parallel zu schalten. Auch kann vorgesehen sein die Kühlkanäle 9 und 10 gruppenweise parallel zu schalten und die sich daraus ergebenden Gruppen gleicher Strömungsrichtung mit den Gruppen entgegengesetzter Strömungsrichtung hintereinander in Reihe zu schalten. Auch können insbesondere bei kleineren Solarzellenmodulen alle Kühlkanäle 9 und 10 parallel geschaltet sein. Die jeweils zu wählende Schaltungsart bzw. Verbindungsart ist von den jeweiligen Kühlausgaben abhängig und kann für den jeweiligen Anwendungsfall auch empirisch bezüglich der erreichbaren oder erforderlichen Kühlleistung empirisch ermittelt werden.

Fig. 5 zeigt nochmals eine perspektivische Darstellung eines komplett zusammengesetzten Kühlelementes 1. Es ist erkennbar, dass insbesondere die Rohrstutzen 14 und 15 an den jeweiligen Stirnwänden 3 und 4 feststehend angeordnet sind, was beispielsweise durch eine Schweißverbindung oder dgl. bewerkstelligt sein kann. Die Strömung des Kühlmediums erfolgt in den oberseitigen Kühlkanälen 9 (gestrichelt dargestellt) aufgrund der oben beschriebenen Verbindungskanäle 17 und 20 stets in Richtung des Pfeils 16 während die Strömung des Kühlmedium in den unterseitigen in Fig. 5 gestrichelt erkennbaren Kühlkanälen 10 in Richtung des Pfeils 19 erfolgt.

Dies bedeutet, dass bei dem in den Fig. 1 bis Fig. 5 beispielhaft dargestellten Ausführungsbeispiel des Kühlelementes 1 diesem über den Rohrstutzen 14 entsprechendes Kühlmedium zuführbar und über den Rohrstutzen 15 entnehmbar ist. Dabei kann, je nach Ausgestaltung des Kühlelementes 1 bzw. der Anordnung und Ausgestaltung der Verteilerplatte 2 der Kühlelementkassette 1 auch vorgesehen sein, dass sowohl der Zufluss als auch der Abfluss des Kühlmediums nur im Bereich der rechten Stirnwand 3 oder der linken Stirnwand 4 erfolgt.

Weiter ist aus Fig. 5 ersichtlich, dass die Kühlelementkassette 1 als komplettes Bauteil rückseitig an einem Solarmodul ansetzbar ist. Zur feststehenden rückseitigen Montage dieses Kühlelementes 75 an einem Solarmodul kann hier beispielsweise eine Klebverbindung oder dgl. vorgesehen sein. Auch kann die Kühlelementkassette 1 bzw. das Kühlelement 75 über metallische Klammern oder dgl. feststehend an einem Solarzellenmodul befestigt sein. Es ist insbesondere aus Fig. 5 ersichtlich, dass die oberseitige Deckplatte 7 für die Kühlkanäle 9 und 10 eine einheitliche Kanalwand mit einer vollständig ebenen Oberfläche 21 bildet, so dass das Kühlelement 75 vollständig mit einem Solarzellenmodul flächig in Kontakt bringbar ist.

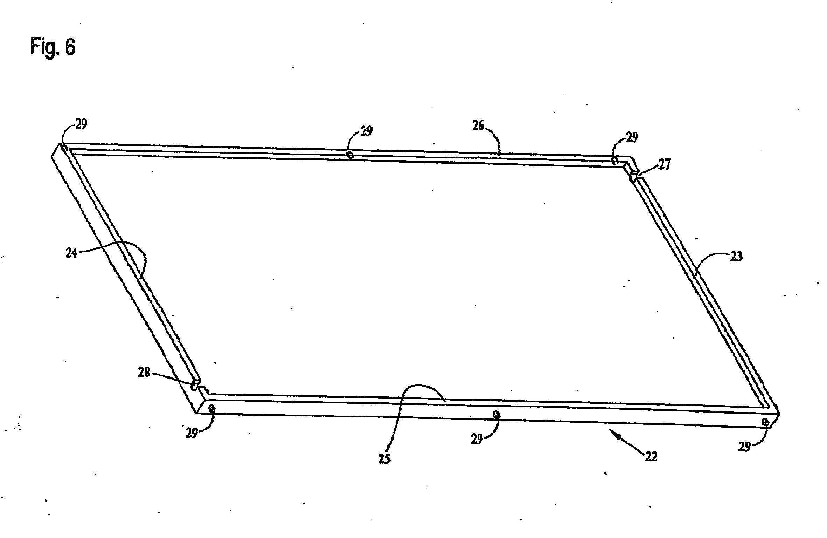

Des Weiteren kann diese Kühlelementkassette 1 auch in ein Montageelement 22 eingesetzt sein, wie dies beispielhaft in Fig. 6 in perspektivischer Darstellung gezeigt ist. Dieses Montageelement 22 bildet insgesamt vier nach oben vorstehende Aufnahmestege 23, 24, 25 und 26, welche beim vorliegenden Ausführungsbeispiel vollständig umlaufen. Der rechte Aufnahmesteg 23 weist dabei einen Durchbruch 27 auf, durch welchen beispielsweise der Rohrstutzen 14 des Kühlelementes 1 im montierten Zustand hindurch geführt ist. Entsprechend der Anordnung des zweiten Rohrstutzens 15 ist auch der linke Aufnahmesteg 24 mit einem Durchbruch 28 versehen. Weiter ist aus Fig. 6 erkennbar, dass beim vorliegenden Ausführungsbeispiel im Bereich des Aufnahmesteges 25 sowie des Aufnahmesteges 26 nach außen vorstehende Gewindezapfen 29 vorgesehen sind, über welche das Montageelement 22 mit einem Solarmodul feststehend koppelbar ist.

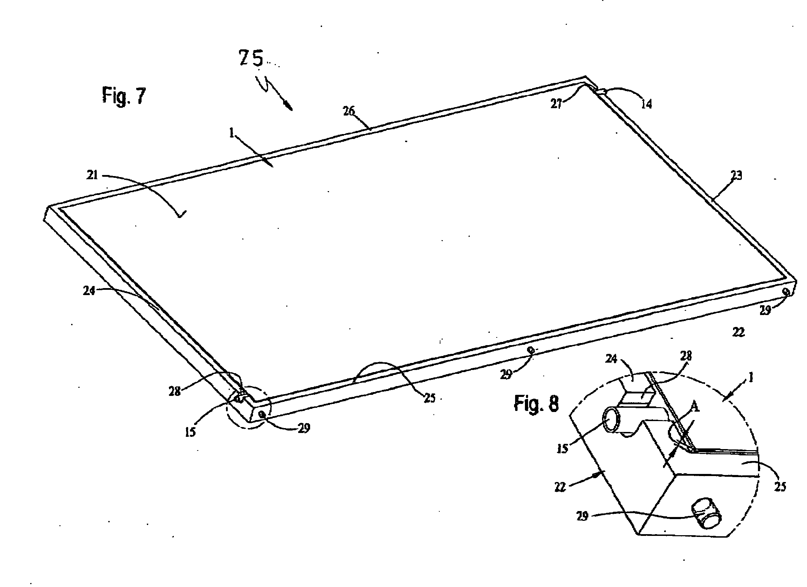

Fig. 7 zeigt das Montageelement 22 mit einem eingesetzter Kühlelementkassette 1. Dabei ist erkennbar, dass der Rohrstutzen 14 den Durchbruch 27 nach außen durchragt. Desgleichen gilt auch für den Rohrstutzen 15, welcher passend durch den Durchbruch 28 hindurchgeführt ist. Dabei ist aus Fig. 7 erkennbar, dass das Kühlelement 75 passend zwischen die Aufnahmestege 23, 24, 25 und 26 eingesetzt ist. Dabei überragt die der Kühlelementkassette 1 die Aufnahmestege 23 bis 28 in vertikaler Richtung nach oben, zu einem in Fig. 7 nicht dargestellten Solarzellenmodul hin. Dies ist insbesondere aus der vergrößerten Darstellung der Fig. 8 erkennbar, in welcher dieser Überstand mit dem Bezugszeichen A gekennzeichnet ist.

Auch ist ersichtlich, dass der Rohrstutzen 15 im Durchbruch 28 des linken Aufnahmesteges 24 aufgenommen ist. Dieser vertikale Überstand A der Kühlelementkassette 1 über die Aufnahmestege 24 und 25 entspricht, wie dies aus Fig. 8 ersichtlich ist, wenigstens etwa der Materialstärke eines ein Solarzellenmodul umgebendes Rahmenteils. Damit wird sichergestellt, dass das Solarzellenmodul passend auf das Kühlelement 75 aufsetzbar ist, ohne dass diese relativ zueinander verschoben werden können. Andererseits wird auch ein sicherer vollflächiger Kontakt zwischen der ebenen Rückseite; des Solarzellenmoduls und der ebenen Oberfläche 21 (Fig. 7) der Kühlelementkassette 1 des Kühlelementes 75 erreicht. Zur feststehenden Montage eines solchen Solarzellenmoduls am Montageelement 22 und somit am Kühlelement 75 sind, wie bereits oben erwähnt, die Gewindezapfen 29 vorgesehen.

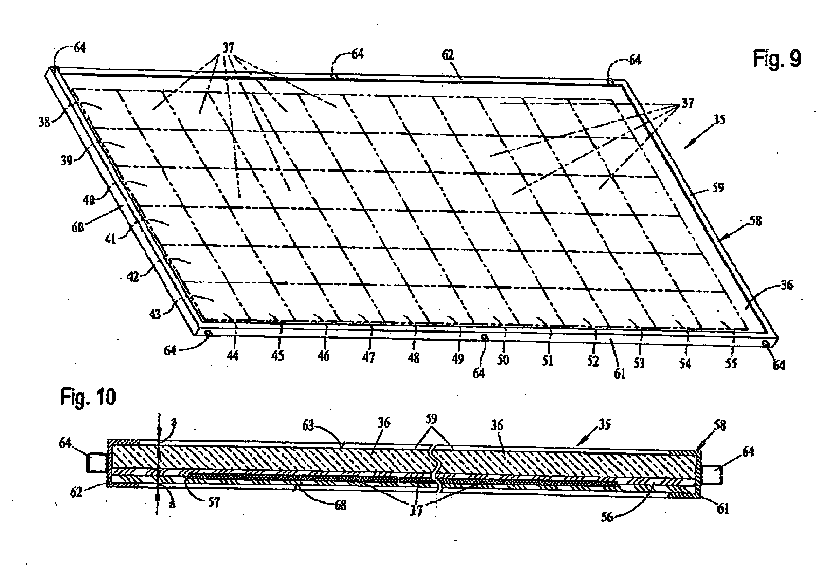

In den Fig. 9 und Fig. 10 ist beispielhaft eine Ausgestaltungsvariante eines solchen Solarzellenmoduls 35 dargestellt. Dieses Solarzellenmodul 35 weist, wie dies insbesondere aus Fig. 10 ersichtlich ist, eine oberseitig angeordnete Glasplatte 36 auf sowie mehrere in einer rechteckigen Matrix angeordnete Solarzellen 37. Diese Solarzellen 37 sind beim dargestellten Ausführungsbeispiel in insgesamt sechs nebeneinander liegenden Spalten 38 bis 43 und zwölf Reihen 44 bis 55 unterhalb der Glasplatte 36 angeordnet. Diese Anordnung unterhalb der Glasplatte 36 ist insbesondere aus Fig. 10 ersichtlich. Des Weiteren ist aus Fig. 10 ersichtlich, dass unterhalb der Glasplatte 36 eine Kunststoffschicht 56 vorgesehen ist, unterhalb derer wiederum eine Schutzfolie 57 angeordnet ist. Diese Kunststoffschicht 56 und diese Schutzfolie 57 werden in Laminiertechnik unterhalb der Glasplatte 36 aufgebracht, wobei zwischen der Kunststoffschicht 56 und der Schutzfolie 57 die oben erwähnten Solarzellen 37 nach dem Laminiervorgang eingebettet sind, wie dies aus dem Stand der Technik für Solarzellenmodule bekannt ist.

Des Weiteren ist aus den Fig. 9 und Fig. 10 erkennbar, dass die Glasplatte 36, die Kunststoffschicht 56, die Schutzfolie 57 sowie die eingebetteten Solarzellen 37 durch einen umlaufenden Profilrahmen 58 eingefasst sind. Dabei besteht dieser Profilrahmen 58 aus zwei Querprofilen 59 und 60 sowie zwei Längsprofilen 61 und 62. In der Darstellung der Fig. 10 sind dabei die beiden Längsprofile 61 und 62 sowie das rechte Querprofil 59 aus Fig. 9 erkennbar. Die Querprofile 59, 60 sowie die Längsprofile 61 und 62 weisen dabei eine U-förmig ausgebildete Querschnittsform auf, wie dies aus Fig. 10 für die Längsprofile 61 und 62 erkennbar ist.

Aufgrund der endlichen Materialstärke dieser Querprofile 59, 60 bzw. Längsprofile 61 und 62 bilden diese mit ihren U-Schenkeln einen Überstand A zur Oberfläche 63 der Glasplatte 36 des Solarzellenmoduls 35 und auch einen Überstand A zur ebenen Rückseite 68 des Solarmoduls 35. Auf dieses Maß A des Überstandes ist der zu Fig. 8 beschriebene Überstand A der Kühlelementkassette 1 über die Aufnahmestege 23 bis 26 des Montageelementes 22 abgestimmt, so dass ein sicherer flächiger Kontakt des Kühlelementes 1 mit der unterseitigen Rückseite 68 des Solarzellenmoduls gewährleistet ist. Weiter ist aus den Fig. 9 und Fig. 10 erkennbar, dass die Längsprofile 61 und 62 mit nach außen vorstehenden Gewindezapfen 64 versehen sind, über welche das Solarzellenmodul 35 mit dem Montageelement 22 feststehend koppelbar ist.

Die in Fig. 5 vollständig dargestellte Kühlelementkassette 1 ist in seinen Außenabrnessungen derart ausgebildet, dass diese auf die Rückseite 68 des Solarzellenmoduls 35 aufsetzbar ist und zwischen den Querprofilen 59 , 60 und den Längsprofilen 61 und 62 passend aufgenommen ist. Dabei können die Querprofile 59 und 60 sowie die Längsprofile 61 und 62 im montierten Zustand auf den Aufnahmestegen 23, 24, 25 und 26 des Montageelementes 22 flächig aufliegen. Dies allerdings nur insoweit, als ein sicherer flächiger und damit thermischer Kontakt zwischen der Oberfläche 21 des Kühlelementes 1 und der Rückseite 68 des Solarzellenmoduls gewährleistet ist. Der Überstand A der Kühlelementkassette 1 über die Aufnahmestege 23 bis 26 hinaus (Fig. 8) ist folglich vorzugsweise minimal größer zu wählen als der Überstand a des Profilrahmens 58 zur Rückseite 68 des Solarzellenmoduls 35.

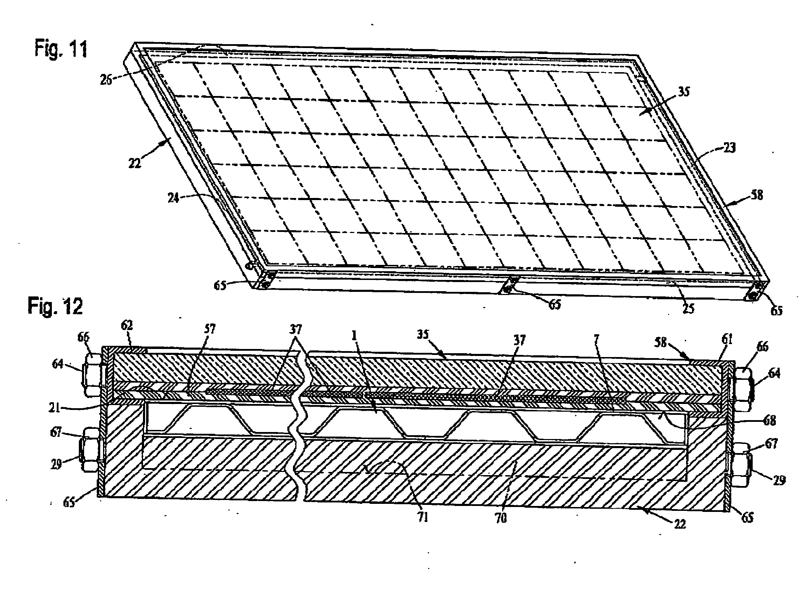

Fig. 11 zeigt das auf dem Montageelement 22 aufgesetzte Solarzellenmodul 35 in perspektivischer Darstellung. Es ist erkennbar, dass das Solarzellenmodul 35 mit seinem Profilrahmen 58 passend auf dem Montageelement 22 aufliegt. Zur feststehenden Montage des Solarzellenmoduls 35 auf dem Montagelement 22 sind beim vorliegenden Ausführungsbeispiel mehrere Haltelaschen 65 vorgesehen, wie dies Insbesondere aus den Fig. 11 und Fig. 12 ersichtlich ist.

Des Weiteren ist aus Fig. 12 erkennbar, dass die Kühlelementkassette 1 des Kühlelements 75 mit seiner Deckplatte 7 flächig unterseitig an der Schutzfolie 57 anliegt. Durch diese flächige Anlage des Kühlelementes 75 unterseitig an der Schutzfolie 57 wird eine optimale Wärmeübertragung auf die Kühlelementkassette 1 erreicht. Dies hat wiederum zur Folge, dass die Solarzellen 37 ebenfalls auf eine gewünschte Temperatur heruntergekühlt werden können. Weiter ist aus Fig. 12 ersichtlich, dass die Kühlelementkassette 1 passend in den Profilrahmen 58 eingesetzt ist, was insbesondere für die beiden Längsprofile 61 und 62 erkennbar ist. Auch sind in Fig, 12 entsprechende Montagemuttem 66 und 67 erkennbar, welche zur feststehenden Halterung des Solarzellenmoduls 35 am Montageelement 22 auf die entsprechenden Gewindezapfen 29 bzw. 64 aufgeschraubt sind. An dieser Stelle sei angemerkt, dass das Montageelement 22 aus einem metallischen oder auch einem isolierenden Kunststoffwerkstoff gebildet sein kann. Auch kann, wie dies aus Fig. 12 in Phantomlinien dargestellt ist, unterhalb des Kühlelementes 1 eine Isolierschicht 70 vorgesehen sein, welche in einen entsprechenden Aufnahmeraum 71 des Montageelementes 22 eingesetzt ist.

Für die Herstellung des Kühlelamentes 1 sind viele Ausführungsvarianten denkbar. So zeigt Fig. 2a insbesondere eine Ausführungsvariante, bei welcher die Kühlelementkassette 1 eine etwa zickzackförmig ausgebildete Verteilerwand 2 bildet Damit erhalten insbesondere die Kühlkanäle 9 und 10 eine Dreiecksform und können dementsprechend auch wie zur Ausführungsvariante der Fig. 1 und Fig. 2 beschrieben gegensinnig durchströmt werden. Bei dieser Ausgestaltung nach Fig. 2a kann allerdings eine Kühlung auch dadurch erreicht werden, dass lediglich die oberseitigen Kühlkanäle 9 mit einem Kühlmedium durchströmt werden. Eine flächige Anlage und optimale Kühlwirkung ist auch hier gewährleistet, da die Verbindungsbereiche 31 insbesondere zur oberen Deckplatte 7 nur linienförmig ausgebildet sind, so dass eine Kühlwirkung in diesen Bereich nur geringfügig eingeschränkt ist. Bezüglich der Formgebung dieser Verteilerplatte 2 sind auch weitere Gestaltungen durchaus denkbar. Insbesondere können die oberen Kühlkanäle 9 auch einen halbzylindrischen Querschnitt aufweisen, so dass lediglich diese mit Kühlmedium zu durchströmen sind.

Es ist erkennbar, dass durch die beispielhaft dargestellten Ausführungsvariante des Kühlelementes 75 insbesondere eine äußerst effektive Kühlung bzw. Temperierung der in einem Solarzellenmodul 35 angeordneten Solarzellen 37 erfolgt. Insbesondere durch die großflächige Anlage des Kühlelementes unterseitig am Solarmodul 35 ist ein optimaler thermischer Wärmeübergang zum Kühlelement 75 erreichbar. Damit wird eine effektive Kühlung bzw. Temperierung insbesondere der eingebetteten Solarzellen 37 erreicht, so dass diese stets auf einer optimalen einen möglichst hohen elektrischen Wirkungsgrad aufweisenden Temperatur gehalten werden können.

## Patentansprüche

1. Kühlelement (75) für ein Solarzellenmodul (35), das mehrere matrixartig angeordnete Solarzellen (37) aufweist, die zusammen eine ebene Modulrückseite (68) bilden, mit mehreren parallel zueinander verlaufenden, nebeneinander angeordneten Kühlkanälen (9,10), welche jeweils eine zum Solarzellenmodul (35) hin gerichtete ebene Kanalwand (7,21) zum flächigen Kontaktieren der Modulrückseite (68) aufweisen, wobei die Kühlkanäle (9, 10) von einem Kühlmedium durchströmt sind und in Strömungsrichtung (16,19) über Verbindungskanäle (17, 20) miteinander verbunden sind, **dadurch gekennzeichnet, dass** das Kühlelement (75) mindestens eine Kühlelementkassette (1) aufweist, deren Kühlkanäle (9, 10) über die Verbindungskanäle (17,20) einzeln oder gruppenweise parallel und/oder hintereinander geschaltet sind.

2. Kühlelement nach Anspruch 1, **dadurch gekennzeichnet, dass** die Kühlelementkassette (1) von einer Deckplatte (7), einer inneren Verteilerplatte (2) und einer Bodenplatte (8) gebildet ist, wobei die Verteilerplatte (2) wellenartig ausgebildet ist und oberseitig durch die Deckplatte (7) und unterseitig durch die Bodenplatte (8) vollflächig unter Ausbildung der Kühlkanälen (9, 10) abgedeckt ist.

3. Kühlelement nach Anspruch 2, **dadurch gekennzeichnet, dass** die Verbindungskanäle (17, 20) als zwischen den Kühlkanälen (9, 10) angeordnete Durchbrüche (17, 20) ausgebildet sind, welche in den Endbereichen der Verteilerplatte (2) in der Verteilerplatte (2) angeordnet sind.

4. Kühlelement nach Anspruch 2 oder 3, **dadurch gekennzeichnet, dass** die Verteilerplatte (2), die Deckplatte (7) und die Bodenplatte (8) durch umlaufend angeordnete Stirnwände (3, 4) und Seitenwände (5, 6) miteinander feststehend in Verbindung stehen.

5. Kühlelement nach einem der Ansprüche 2 bis 4, **dadurch gekennzeichnet, dass** zur Zuführung und zum Abführen des Kühlmediums wenigstens zwei Rohrstutzen (14, 15) vorgesehen sind, welche vorzugsweise in den seitlichen Endbereichen wenigstens einer der Stirnwände (3, 4) angeordnet sind.

6. Kühlelement nach einem der Ansprüche 1 bis 5, **dadurch gekennzeichnet, das** ein Montagelement (22) vorgesehen ist, in welches die mindestens eine Kühlelementkassette (1) einsetzbar ist.

7. Kühlelement nach Anspruch 6, **dadurch gekennzeichnet, dass** das Montagelement (22) mit zumindest teilweise umlaufenden Aufnahmestegen (23, 24, 25, 26) versehen ist, welche zur positionsgenauen Aufnahme der Kühlelementkassette (1) dienen.

8. Kühlelement nach Anspruch 6 oder 7, **dadurch gekennzeichnet, dass** die Aufnahmestege (23, 24, 25, 26) im Bereich der Rohrstutzen (14,15) Durchbrüche (27, 28) aufweisen, durch welche die Rohrstutzen (14, 15) nach außen aus dem Montagelement (22) herausgeführt sind.

9. Kühlelement nach einem der Ansprüche 6 bis 8, **dadurch gekennzeichnet, das** die mindestens eine in das Montageelement (22) eingesetzte Kühlelementkassette (1) im am Solarzellenmodul (35) montierten Zustand in einem Profilrahmen (58) des Solarzellenmoduls (35) passend aufgenommen ist.

10. Kühlelement nach Anspruch 9, **dadurch gekennzeichnet, dass** die in das Montagelement (22) eingesetzte Kühlelementkassette (1) die Aufnahmestege (23, 24, 25, 26) des Montageelementes (22) zum Solarzellenmodul (35) hin um ein Maß (A) überragt, welches zumindest dem Überstand (a) des Profilrahmens (58) des Solarmoduls (35) zu der Kühlelementkassette (1) hin entspricht
